# EUROPEAN PATENT APPLICATION

(11) **EP 4 707 921 A1**
(43) Date of publication of application: **11.03.2026**
(21) Application number: 25184867.7
(22) Date of filing: 24.06.2025
(51) Int. Cl.: G03F 7/00, G03F 9/00, H10W 90/00

(54) **SEMICONDUCTOR MANUFACTURING APPARATUS AND PARAMETER ADJUSTMENT METHOD THEREOF**

(30) Priority: 06.09.2024 JP 2024153700
(71) Applicant: Winbond Electronics Corp., Taichung City, Taiwan. (TW)
(72) Inventor: SEGAWA, Kazuhiro, Taichung City (TW)
(74) Representative: Becker, Eberhard

(57) **Abstract**

A semiconductor manufacturing apparatus and a parameter adjustment method thereof are provided. Before a process device (114) performs a patterning process, an alignment mark of a wafer is measured to generate position data and quality data of the alignment mark. An alignment recipe parameter used by the process device (114) to perform the patterning process and wafer bonding and an overlay recipe parameter used by a measuring device (112) to measure a relative position of the alignment mark of the wafer are calibrated based on the position data and the quality data.

## Description

### BACKGROUND

### Technical Field

The disclosure relates to a semiconductor apparatus, and particularly relates to a semiconductor manufacturing apparatus and a parameter adjustment method thereof.

### Description of Related Art

In the semiconductor process, alignment marks may be formed on the wafer to check the alignment between the front and back layers. However, changes in the process may cause the optimized alignment recipe parameter and overlay recipe parameter to no longer be applicable, thereby affecting the yield and throughput of the semiconductor process.

### SUMMARY

The disclosure provides a semiconductor manufacturing apparatus and a parameter adjustment method thereof, which may automatically modify an alignment recipe parameter and an overlay recipe parameter in real time to improve overlay accuracy, thereby preventing a decrease in yield and throughput of the semiconductor process.

A semiconductor manufacturing apparatus of the disclosure includes a process device, a measuring device, and a control device. The measuring device measures an alignment mark of a wafer before the process device performs a patterning process, and generates position data and quality data of the alignment mark. The control device is coupled to the process device and the measuring device. The control device calibrates an alignment recipe parameter used by the process device to perform the patterning process and wafer bonding and an overlay recipe parameter used by the measuring device to measure a relative position of the alignment mark of the wafer based on the position data and the quality data.

The disclosure also provides a parameter adjustment method of a semiconductor manufacturing apparatus. The semiconductor manufacturing apparatus includes a process device and a measuring device. The parameter adjustment method of the semiconductor manufacturing apparatus includes the following steps. Before the process device performs a patterning process, an alignment mark of a wafer is measured to generate position data and quality data of the alignment mark. An alignment recipe parameter used by the process device to perform the patterning process and wafer bonding and an overlay recipe parameter used by the measuring device to measure a relative position of the alignment mark of the wafer are calibrated based on the position data and the quality data.

Based on the above, embodiments of the disclosure may measure the alignment mark of the wafer before performing the patterning process to generate the position data and the quality data of the alignment mark, and may calibrate the alignment recipe parameter used to perform the patterning process and wafer bonding and the overlay recipe parameter used to measure the relative position of the alignment mark of the wafer based on the position data and the quality data, so that the alignment recipe parameter and the overlay recipe parameter are automatically modified in real time in response to process changes, thereby improving overlay accuracy and preventing a decrease in yield and throughput of the semiconductor process.

### BRIEF DESCRIPTION OF THE DRAWINGS

FIG. 1 is a schematic diagram of a semiconductor manufacturing apparatus according to an embodiment of the disclosure.
FIG. 2 and FIG. 3 are flowcharts of a parameter adjustment method of a semiconductor manufacturing apparatus according to an embodiment of the disclosure.

### DESCRIPTION OF THE EMBODIMENTS

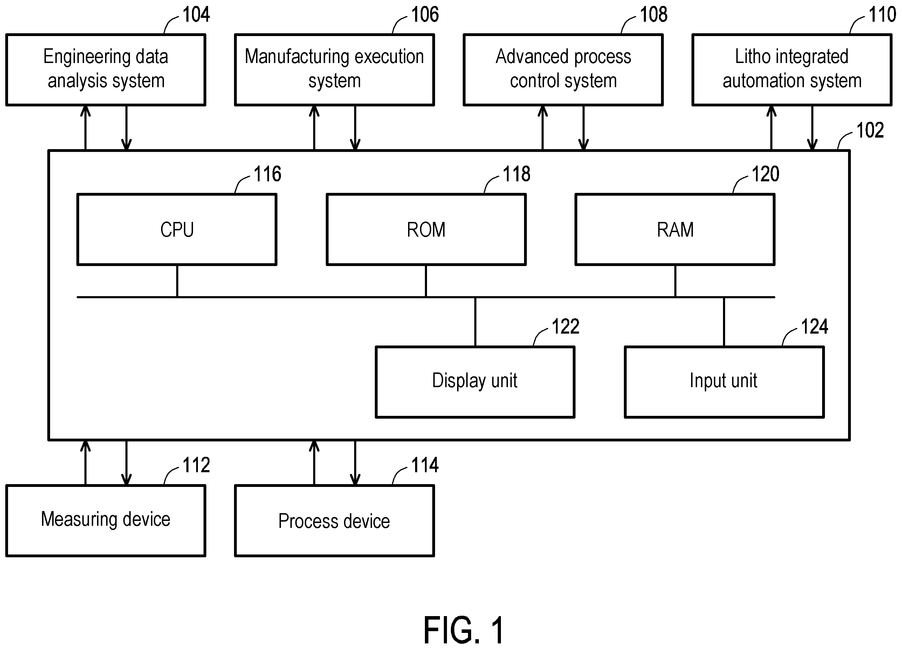

Referring to FIG. 1, a semiconductor manufacturing apparatus may include a control device 102, an engineering data analysis system 104, a manufacturing execution system 106, an advanced process control system 108, a litho integrated automation system 110, a measuring device 112, and a process device 114. The control device 102 is coupled to the engineering data analysis system 104, the manufacturing execution system 106, the advanced process control system 108, the litho integrated automation system 110, the measuring device 112, and the process device 114.

The control device 102 may be, for example, a host computer, but is not limited thereto. The control device 102 includes a central processing unit (CPU) 116, a read only memory (ROM) 118, a random access memory (RAM) 120, a display unit 122, and an input unit 124. The CPU 116, the ROM 118, the RAM 120, the display unit 122, and the input unit 124 may be connected via a bus.

The CPU 116 may execute a patterning support program to support pattern forming on the wafer, such as supporting position calibration of a plurality of patterns. The patterning support program is a computer-executable computer program having a computer-readable recording medium. The computer-readable recording medium may include a plurality of instructions for calculating position calibration parameters required for position calibration of the pattern. The instructions of the patterning support program may enable the computer to perform position calibration parameter calculation processing. The patterning support program may be stored in the ROM 118 and loaded into the RAM 120 via the bus.

The input unit 124 may include, for example, a mouse and/or a keyboard, and may receive instruction information externally input by the user, and transmit the instruction information to the CPU 116.

The CPU 116 may read the patterning support program from the ROM 118 according to the instruction input by the user from the input unit 124, and expand the patterning support program in the program storage area of the RAM 120 to perform various types of processing. The CPU 116 temporarily stores various data generated in the various types of processing in a data storage area formed in the RAM 120.

The display unit 122 may be, for example, a display device such as a liquid crystal display, and displays the status of the semiconductor manufacturing apparatus, measurement data, and the like based on instructions from the CPU 116.

The engineering data analysis system 104, the manufacturing execution system 106, the advanced process control system 108, the litho integrated automation system 110 may be executed by the control device 102 and controlled by the control device 102. The engineering data analysis system 104 is used to analyze the process data to find out the reasons for process parameter variation or output loss. The manufacturing execution system 106 may be used to control the manufacturing process and manufacturing management of the semiconductor manufacturing apparatus. The advanced process control system 108 may be used to perform fault detection and classification (FDC) and run-to-run control (R2R). The litho integrated automation system 110 is used to perform automated control of the lithography process. A computer integrated manufacturing system composed of such system as the engineering data analysis system 104, the manufacturing execution system 106, the advanced process control system 108, and the litho integrated automation system 110 may integrate and manage activities in the semiconductor process.

The process device 114 may include, for example, a patterning tool, such as a mask aligner, and a wafer bonder, but is not limited thereto. The measuring device 112 may include, for example, measuring tools such as a stand-alone pre-aligner and an overlay metrology machine, but is not limited thereto. The measuring device 112 may measure the alignment mark of the wafer before the process device 114 performs the patterning process to generate position data and quality data of the alignment mark. The position data may include, for example, the absolute position (such as coordinate position) of the alignment mark. The quality data may include, for example, the measuring device 112 measuring the contrast of the image obtained by the reflected light generated by the alignment mark reflecting the incident light beam, but is not limited thereto. For example, the quality data may also include normalized image log slope, correlation coefficient, etc., but is not limited thereto.

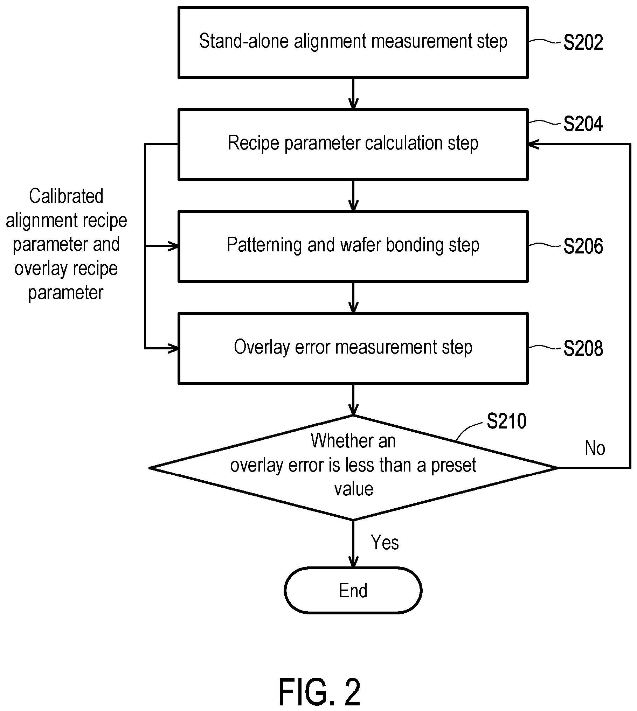

As shown in FIG. 2, the measuring device 112 may measure the alignment mark of the wafer in step S202 first to generate the position data and the quality data of the alignment mark. In step S204, the control device 102 may automatically perform calculations for calibrating recipe parameters, such as calibrating an alignment recipe parameter and an overlay recipe parameter based on the position data and quality data of the alignment mark. The alignment recipe parameter is the alignment recipe parameter used by the process device 114 to perform the patterning process and wafer bonding. The overlay recipe parameter is the overlay recipe parameter used by the measuring device 112 to measure the relative position of the alignment mark of the wafer. The calibrated alignment recipe parameter and overlay recipe parameter are then fed forward in real time to the patterning and wafer bonding step S206 and the overlay error measurement step S208, so that the calibrated alignment recipe parameter is used to perform the patterning process and wafer bonding, and the calibrated overlay recipe parameter is used to perform the overlay error measurement. After step S208, it may be determined whether the overlay error is less than the preset value. If the overlay error is less than the preset value, the adjustment of the alignment recipe parameter and the overlay recipe parameter may be stopped. If the overlay error is not less than the preset value, then step S204 may be returned to correct the alignment recipe parameter and the overlay recipe parameter again.

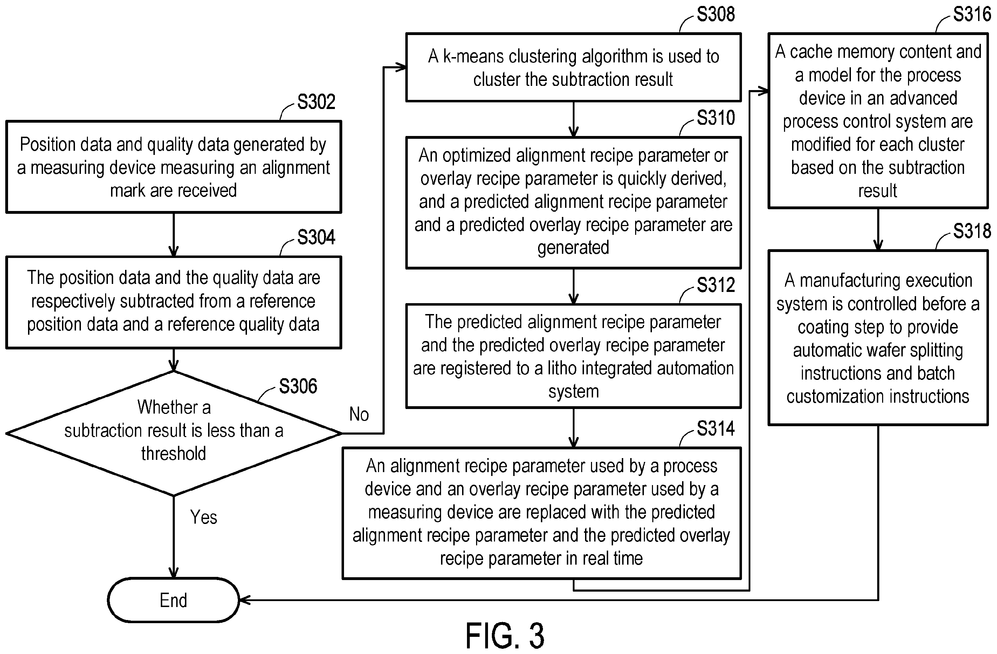

Furthermore, the manner in which the control device 102 calibrates the alignment recipe parameter and the overlay recipe parameter is as shown in FIG. 3. First, the position data and the quality data generated by the measuring device 112 measuring the alignment mark (step S302) are received. For example, the position data and quality data provided by the stand-alone pre-aligner are received. Then, the position data is subtracted from a reference position data (for example, the absolute position coordinates are subtracted from the preset position coordinates, but not limited thereto) to generate a first subtraction result, and the quality data is subtracted from a reference quality data (for example, the contrast of the image of the alignment mark is subtracted from the preset contrast, but not limited thereto) to generate a second subtraction result (step S304). The reference position data and the reference quality data may be, for example, the reference position data and the reference quality data of the current batch (lot) or the previous batch in the engineering data analysis system.

The control device 102 also determines whether the first subtraction result is less than a first threshold, and whether the second subtraction result is less than a second threshold (step S306). When the first subtraction result is less than the first threshold and the second subtraction result is less than the second threshold, the calculation of the recipe parameters may be ended. When the first subtraction result is not less than the first threshold or the second subtraction result is not less than the second threshold, the control device 102 may calibrate the alignment recipe parameter and the overlay recipe parameter based on the first subtraction result and the second subtraction result. For example, the k-means clustering algorithm may be used to cluster the first subtraction result and the second subtraction result to generate a plurality of clusters (step S308). Then, the optimized alignment recipe parameter or overlay recipe parameter is quickly derived for each cluster to generate a predicted alignment recipe parameter and a predicted overlay recipe parameter (step S310). For example, the subtraction result of the absolute position coordinates and the preset position coordinates may be used to correct the alignment recipe parameter (such as a pattern position compensation value or an alignment calibration model), and the subtraction result of the contrast of the image of the alignment mark and the preset contrast may be used to correct the overlay recipe parameter (such as the wavelength of the measurement beam), but is not limited thereto. In some embodiments, the position data, the quality data, the reference position data, and the reference quality data may also be input into the machine learning model to determine the type of the alignment mark, the optimized wavelength or color, the measurement focus, and the measurement position...etc, and the alignment recipe parameter and the overlay recipe parameter are modified accordingly to generate the predicted alignment recipe parameter and the predicted overlay recipe parameter.

The control device 102 may register the predicted alignment recipe parameter and the predicted overlay recipe parameter to the litho integrated automation system 110 (step S312), and control the litho integrated automation system 110 and the manufacturing execution system 106 to replace the alignment recipe parameter used by the process device 114 and the overlay recipe parameter used by the measuring device 112 with the predicted alignment recipe parameter and the predicted overlay recipe parameter in real time (step S314), so as to enable the process device 114 and the measuring device 112 to use the predicted alignment recipe parameter and the predicted overlay recipe parameter to more accurately perform the patterning process, wafer bonding, and overlay error measurement, thereby improving overlay accuracy and avoiding a decrease in yield and throughput of the semiconductor process.

In addition, the control device 102 may also modify a cache memory content and a model for the process device 114 in the advanced process control system 108 for each cluster based on the first subtraction result (step S316). For example, the pattern position compensation value stored in the advanced process control system 108 may be modified, but is not limited thereto. In addition, the control device 102 may also control the manufacturing execution system 106 to provide automatic wafer splitting instructions and batch customization instructions before the coating step (step S318).

In summary, embodiments of the disclosure may measure the alignment mark of the wafer before performing the patterning process to generate the position data and the quality data of the alignment mark, and may calibrate the alignment recipe parameter used to perform the patterning process and wafer bonding and the overlay recipe parameter used to measure the relative position of the alignment mark of the wafer based on the position data and the quality data, so that the alignment recipe parameter and the overlay recipe parameter are automatically modified in real time in response to process changes, thereby improving overlay accuracy and avoiding a decrease in yield and throughput of the semiconductor process.

## Claims

1. A semiconductor manufacturing apparatus, comprising:
a process device (114);
a measuring device (112), configured to measure an alignment mark of a wafer before the process device (114) performs a patterning process to generate position data and quality data of the alignment mark; and
a control device (102), coupled to the process device (114) and the measuring device (112), and configured to calibrate an alignment recipe parameter used by the process device (114) to perform the patterning process and wafer bonding and an overlay recipe parameter used by the measuring device (112) to measure a relative position of the alignment mark of the wafer based on the position data and the quality data.

2. The semiconductor manufacturing apparatus according to claim 1, wherein the control device (102) also subtracts the position data from a reference position data to generate a first subtraction result, and subtracts the quality data from a reference quality data to generate a second subtraction result, and in response to the first subtraction result being not less than a first threshold or the second subtraction result being not less than a second threshold, the alignment recipe parameter and the overlay recipe parameter are calculated based on the first subtraction result and the second subtraction result.

3. The semiconductor manufacturing apparatus according to claim 2, further comprising a manufacturing execution system (106) and a litho integrated automation system (110) coupled to the control device (102), wherein the control device (102) uses a clustering algorithm to cluster the first subtraction result and the second subtraction result to generate a plurality of clusters, optimizes an alignment recipe parameter or an overlay recipe parameter corresponding to each cluster to generate a predicted alignment recipe parameter and a predicted overlay recipe parameter, and controls the litho integrated automation system (110) and the manufacturing execution system (106) to replace the alignment recipe parameter used by the process device (114) and the overlay recipe parameter used by the measuring device (112) with the predicted alignment recipe parameter and the predicted overlay recipe parameter.

4. The semiconductor manufacturing apparatus according to claim 2, further comprising an advanced process control system (108) coupled to the control device (102), wherein the control device (102) modifies a cache memory content and a model used for the process device (114) in the advanced process control system (108) based on the first subtraction result.

5. The semiconductor manufacturing apparatus according to claim 4, wherein the control device (102) also modifies a pattern position compensation value stored in the advanced process control system (108).

6. The semiconductor manufacturing apparatus according to claim 1, further comprising a manufacturing execution system (106) coupled to the control device (102), wherein the control device (102) further controls the manufacturing execution system (106) to provide automatic wafer splitting instructions and batch customization instructions.

7. A parameter adjustment method of a semiconductor manufacturing apparatus, wherein the semiconductor manufacturing apparatus comprises a process device (114) and a measuring device (112), and the parameter adjustment method of the semiconductor manufacturing apparatus comprises:
before the process device (114) performs a patterning process, measuring an alignment mark of a wafer to generate position data and quality data of the alignment mark; and
calibrating an alignment recipe parameter used by the process device (114) to perform the patterning process and wafer bonding and an overlay recipe parameter used by the measuring device (112) to measure a relative position of the alignment mark of the wafer based on the position data and the quality data.

8. The parameter adjustment method of the semiconductor manufacturing apparatus according to claim 7, comprising:
subtracting the position data from a reference position data to produce a first subtraction result, and subtracting the quality data from a reference quality data to produce a second subtraction result; and
in response to the first subtraction result being not less than a first threshold or the second subtraction result being not less than a second threshold, calculating the alignment recipe parameter and the overlay recipe parameter based on the first subtraction result and the second subtraction result.

9. The parameter adjustment method of the semiconductor manufacturing apparatus according to claim 8, wherein the semiconductor manufacturing apparatus further comprises a litho integrated automation system (110) and a manufacturing execution system (106), and the parameter adjustment method of the semiconductor manufacturing apparatus comprises:
using a clustering algorithm to cluster the first subtraction result and the second subtraction result to generate a plurality of clusters;
optimizing an alignment recipe parameter or an overlay recipe parameter corresponding to each cluster to generate a predicted alignment recipe parameter and a predicted overlay recipe parameter; and
controlling the litho integrated automation system (110) and the manufacturing execution system (106) to replace the alignment recipe parameter used by the process device (114) and the overlay recipe parameter used by the measuring device (112) with the predicted alignment recipe parameter and the predicted overlay recipe parameter.

10. The parameter adjustment method of the semiconductor manufacturing apparatus according to claim 8, wherein the semiconductor manufacturing apparatus further comprises an advanced process control system (108), and the parameter adjustment method of the semiconductor manufacturing apparatus comprises:
modifying a cache memory content and a model for the process device (114) in the advanced process control system (108) based on the first subtraction result.

11. The parameter adjustment method of the semiconductor manufacturing apparatus according to claim 7, wherein the semiconductor manufacturing apparatus further comprises an advanced process control system (108), and the parameter adjustment method of the semiconductor manufacturing apparatus comprises:
modifying a pattern position compensation value stored in the advanced process control system (108).

12. The parameter adjustment method of the semiconductor manufacturing apparatus according to claim 7, wherein the semiconductor manufacturing apparatus further comprises a manufacturing execution system (106), and the parameter adjustment method of the semiconductor manufacturing apparatus comprises:
controlling the manufacturing execution system (106) to provide automatic wafer splitting instructions and batch customization instructions.
